(19) Europäisches Patentamt
European Patent Office
Office européen des brevets

(11) **EP 4 465 059 B1**

(12) **EUROPEAN PATENT SPECIFICATION**

(45) Date of publication and mention of the grant of the patent:
**25.03.2026 Bulletin 2026/13**

(21) Application number: **24176458.8**

(22) Date of filing: **16.05.2024**

(51) International Patent Classification (IPC):
**G01R 31/367** (2019.01)     **G01R 31/389** (2019.01)
**G01R 31/392** (2019.01)

(52) Cooperative Patent Classification (CPC):
**G01R 31/392; G01R 31/367; G01R 31/389;**
Y02E 60/10

(54) **ENERGY STORAGE APPARATUS, METHOD FOR OBTAINING BATTERY STATE OF HEALTH VALUE, AND BATTERY MANAGEMENT SYSTEM**

ENERGIESPEICHERVORRICHTUNG, VERFAHREN ZUM ERLANGEN DES BATTERIEGESUNDHEITSZUSTANDWERTS UND BATTERIEMANAGEMENTSYSTEM

APPAREIL DE STOCKAGE D'ÉNERGIE, PROCÉDÉ D'OBTENTION D'ÉTAT DE BATTERIE DE VALEUR DE SANTÉ ET SYSTÈME DE GESTION DE BATTERIE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **18.05.2023 CN 202310568161**

(43) Date of publication of application:
**20.11.2024 Bulletin 2024/47**

(73) Proprietor: **Huawei Digital Power Technologies Co., Ltd.**
**Shenzhen, Guangdong 518043 (CN)**

(72) Inventor: **XIE, Jie**
**Shenzhen, 518043 (CN)**

(74) Representative: **Gill Jennings & Every LLP**
**The Broadgate Tower**
**20 Primrose Street**
**London EC2A 2ES (GB)**

(56) References cited:
**CN-A- 110 456 279     CN-A- 113 064 093**
**CN-A- 114 814 691**

## Description

### TECHNICAL FIELD

This application relates to the energy field, and more specifically, to an energy storage apparatus, a method for obtaining a battery state of health value, and a battery management system.

### BACKGROUND

With the development of energy storage technologies, a lithium-ion battery is increasingly used in various mobile or fixed devices. To ensure stable operating of the devices, a power supply battery needs to be managed, to identify potential risks of the battery in advance, and perform maintenance in advance to avoid serious consequences. A battery state of health (state of health, SoH) value is an important parameter in a battery management system. The battery state of health indicates a ratio of a real-time capacity to a rated capacity of the battery, and is generally expressed in percentage. The battery SoH value can be obtained by performing a full charge test or a full discharge test on the battery. However, due to a plurality of factors like safety, the battery cannot be fully charged and discharged. Therefore, the battery SoH value cannot be accurately measured.

Currently, a method widely used in the industry is to establish a relationship between a battery retention capacity and an online detection parameter, and estimate the battery SoH value by using a charge/discharge curve. However, the method needs to first obtain an aging model through a prior aging test that requires a heavy workload and a long period. In addition, in a plurality of power backup scenarios, for example, in scenarios such as a data center and a station backup power supply, the battery is in a float charging state for long time, and a voltage and a current almost remain unchanged. The foregoing method for estimating the battery SoH value based on the charge/discharge curve cannot be performed.

The document CN 110 456 279 A discloses a cloud-based real time SOH estimation using an equivalent circuit model. Training data comprises real-time total current and real-time total voltage of the battery, which are used to obtain capacitance and resistance values which are then used to update the equivalent circuit model.

Therefore, an energy storage apparatus is urgently needed to accurately obtain the battery SoH value in the plurality of application scenarios, to identify a battery capacity abnormality risk in advance, and improve stability of an energy storage system.

### SUMMARY

This application provides an energy storage apparatus, a method for obtaining a battery state of health value, and a battery management system, to help accurately obtain the battery state of health SoH value, identify a battery capacity abnormality risk in advance, and improve stability of the energy storage system.

According to a first aspect, an energy storage apparatus is provided, where the energy storage apparatus includes a battery control unit (battery control unit, BCU) and at least one battery pack, the battery pack includes a battery monitor unit (battery monitor unit, BMU) and a plurality of cells, the plurality of cells are connected in series, the battery control unit BCU is connected to the at least one battery pack, and the battery monitor unit BMU is connected to a first cell of the plurality of cells. The battery control unit BCU is configured to receive a battery state of health SoH value estimation model from a cloud device, where the battery SoH value estimation model is obtained by the cloud device through training based on historical equivalent circuit model parameters of the plurality of cells and historical actual SoH values of the plurality of cells, equivalent circuit model parameters of the plurality of cells include at least one of equivalent inductance parameters, equivalent capacitance parameters, and equivalent resistance parameters of the plurality of cells, and the historical equivalent circuit model parameters of the plurality of cells one-to-one correspond to the historical actual SoH values of the plurality of cells. The battery monitor unit BMU is configured to obtain a real-time equivalent circuit model parameter of the first cell, and obtain an estimated SoH value of the first cell based on the real-time equivalent circuit model parameter of the first cell and the battery SoH value estimation model.

According to the energy storage apparatus disclosed in this application, a battery SoH value is estimated by using an artificial intelligence model, and deep charging and discharging do not need to be performed on the battery, so that the battery SoH value can be accurately obtained in a plurality of application scenarios, and a battery capacity abnormality risk can be identified in advance, thereby improving stability of an energy storage system.

With reference to the first aspect, in some implementations of the first aspect, the battery monitor unit BMU is further configured to: send an alternating current excitation electrical signal to the first cell, where a frequency of the alternating current excitation electrical signal is a preset value; and obtain a sampling signal from the first cell, where the sampling signal is used to obtain the real-time equivalent circuit model parameter of the first cell, and the sampling signal includes at least one of voltage information, current information, and temperature information that are of the first cell.

With reference to the first aspect, in some implementations of the first aspect, a frequency at which the battery monitor unit BMU obtains the sampling signal from the first cell is $f_1$, a frequency at which the battery monitor unit BMU sends the alternating current excitation electrical signal to the first cell is $f_2$, and $f_1$ and $f_2$ meet: $f_1 \geq 2f_2$. In this way, a sampling frequency is more than twice a frequency of sending the alternating current excitation electrical signal, and accuracy of the sampling signal can be ensured.

With reference to the first aspect, in some implementations of the first aspect, the battery monitor unit BMU is specifically configured to: parse the sampling signal and the alternating current excitation signal to obtain impedance spectrum information of the first cell; and obtain the real-time equivalent circuit model parameter of the first cell based on the impedance spectrum information of the first cell and a battery equivalent circuit model, where the battery equivalent circuit model is preconfigured or stored in the battery monitor unit BMU.

With reference to the first aspect, in some implementations of the first aspect, the battery control unit BCU is further configured to send the historical equivalent circuit model parameters of the plurality of cells and the historical actual SoH values of the plurality of cells to the cloud device.

With reference to the first aspect, in some implementations of the first aspect, the battery control unit BCU is further configured to send, to the cloud device, the real-time equivalent circuit model parameter of the first cell and an actual SoH value that is of the first cell and that corresponds to the real-time equivalent circuit model parameter of the first cell, where the real-time equivalent circuit model parameter of the first cell and the actual SoH value that is of the first cell and that corresponds to the real-time equivalent circuit model parameter of the first cell are used by the cloud device to update the battery SoH value estimation model, to obtain an updated battery SoH value estimation model. In this way, in use of the battery SoH value estimation model, continuous iteration may be performed based on an actual SoH value of a cell and an estimated SoH value of the cell, thereby improving precision of the battery SoH value estimation model.

With reference to the first aspect, in some implementations of the first aspect, the battery control unit BCU is further configured to receive the updated battery SoH value estimation model from the cloud device.

With reference to the first aspect, in some implementations of the first aspect, a waveform of the alternating current excitation electrical signal includes at least one of a sine wave, a square wave, or a triangular wave.

According to a second aspect, this application provides a method for obtaining a battery state of health SoH value, where the method is executed by an energy storage apparatus, the energy storage apparatus includes at least one battery pack, the battery pack includes a plurality of cells, the plurality of cells are connected in series, and the plurality of cells include a first cell. The method includes: receiving a battery SoH value estimation model from a cloud device, where the battery SoH value estimation model is obtained by the cloud device through training based on historical equivalent circuit model parameters of the plurality of cells and historical actual SoH values of the plurality of cells, equivalent circuit model parameters of the plurality of cells include at least one of equivalent inductance parameters, equivalent capacitance parameters, and equivalent resistance parameters of the plurality of cells, and the historical equivalent circuit model parameters of the plurality of cells one-to-one correspond to the historical actual SoH values of the plurality of cells; and obtaining a real-time equivalent circuit model parameter of the first cell, and obtaining an estimated SoH value of the first cell based on the real-time equivalent circuit model parameter of the first cell and the battery SoH value estimation model.

According to the method disclosed in this application, a battery SoH value is estimated by using an artificial intelligence model, and deep charging and discharging do not need to be performed on the battery, so that the battery SoH value can be accurately obtained in a plurality of application scenarios, and a battery capacity abnormality risk can be identified in advance, thereby improving stability of an energy storage system.

With reference to the second aspect, in some implementations of the second aspect, the method further includes: sending an alternating current excitation electrical signal to the first cell, where a frequency of the alternating current excitation electrical signal is a preset value; obtaining a sampling signal from the first cell, where the sampling signal includes at least one of voltage information, current information, and temperature information that are of the first cell. The obtaining a real-time equivalent circuit model parameter of the first cell includes: parsing the sampling signal and the alternating current excitation signal to obtain impedance spectrum information of the first cell; and obtaining the real-time equivalent circuit model parameter of the first cell based on the impedance spectrum information of the first cell and a battery equivalent circuit model. The battery equivalent circuit model is preconfigured or stored in a battery monitor unit BMU.

With reference to the second aspect, in some implementations of the second aspect, the method further includes: sending the historical equivalent circuit model parameters of the plurality of cells and the historical actual SoH values of the plurality of cells to the cloud device.

With reference to the second aspect, in some implementations of the second aspect, the method further includes: sending, to the cloud device, the real-time equivalent circuit model parameter of the first cell and an actual SoH value that is of the first cell and that corresponds to the real-time equivalent circuit model parameter of the first cell, where the real-time equivalent circuit model parameter of the first cell and the actual SoH value that is of the first cell and that corresponds to the real-time equivalent circuit model parameter of the first cell are used by the cloud device to update the battery SoH value estimation model, to obtain an updated battery SoH value estimation model.

With reference to the second aspect, in some implementations of the second aspect, the method further includes: receiving the updated battery SoH value estimation model from the cloud device.

According to a third aspect, a battery management system is provided, where the system includes an energy storage apparatus and a cloud device. The energy storage apparatus includes at least one battery pack, where the battery pack includes a plurality of cells, the plurality of cells are connected in series, and the plurality of cells include a first cell. The cloud device is configured to send a battery state of health SoH value estimation model to the energy storage apparatus, where the battery SoH value estimation model is obtained by the cloud device through training based on historical equivalent circuit model parameters of the plurality of cells and historical actual SoH values of the plurality of cells, equivalent circuit model parameters of the plurality of cells include at least one of equivalent inductance parameters, equivalent capacitance parameters, and equivalent resistance parameters of the plurality of cells, and the historical equivalent circuit model parameters of the plurality of cells one-to-one correspond to the historical actual SoH values of the plurality of cells. The energy storage apparatus is configured to obtain a real-time equivalent circuit model parameter of the first cell, and obtain an estimated SoH value of the first cell based on the real-time equivalent circuit model parameter of the first cell and the battery SoH value estimation model.

According to the battery management system provided in this application, the energy storage apparatus estimates a battery SoH value by using an artificial intelligence model obtained through training by the cloud device, and deep charging and discharging do not need to be performed on the battery, so that the battery SoH value can be accurately obtained in a plurality of application scenarios, and a battery capacity abnormality risk can be identified in advance, thereby improving stability of an energy storage system.

With reference to the third aspect, in some implementations of the third aspect, the energy storage apparatus is further configured to send the real-time equivalent circuit model parameter of the first cell and an actual SoH value that is of the first cell and that corresponds to the real-time equivalent circuit model parameter of the first cell to the cloud device. The cloud device is further configured to update the battery SoH value estimation model based on the real-time equivalent circuit model parameter of the first cell and the actual SoH value that is of the first cell and that corresponds to the real-time equivalent circuit model parameter of the first cell, to obtain an updated battery SoH value estimation model.

## BRIEF DESCRIPTION OF DRAWINGS

FIG. 1 is a schematic diagram of an application scenario according to this application;

FIG. 2 is a schematic diagram of a structure of an energy storage apparatus according to an embodiment of this application;

FIG. 3 is a schematic diagram of interaction between an energy storage apparatus and a cloud device according to an embodiment of this application;

FIG. 4 is a schematic diagram of a structure in which a battery sampling unit sends an alternating current excitation signal to a first cell according to an embodiment of this application;

FIG. 5 is a schematic diagram of obtaining an equivalent circuit parameter of a cell based on a sampling signal according to an embodiment of this application;

FIG. 6 is a schematic diagram of SoH model training according to an embodiment of this application; and

FIG. 7 shows a correspondence between an equivalent circuit parameter of a cell and an SoH value according to an embodiment of this application.

## DESCRIPTION OF EMBODIMENTS

The following describes technical solutions of this application with reference to accompanying drawings.

Terms used in the following embodiments are merely intended to describe specific embodiments, but are not intended to limit this application. The terms "one", "a" and "this" of singular forms used in this specification and the appended claims of this application are also intended to include expressions such as "one or more", unless otherwise specified in the context clearly. It should be further understood that in the following embodiments of this application, "at least one" and "one or more" refer to one, two, or more. The term "and/or" is used for describing an association relationship between associated objects, and indicates that three relationships may exist. For example, A and/or B may represent: Only A exists, both A and B exist, and only B exists, where A and B may be singular or plural. The character "/" generally indicates an "or" relationship between the associated objects.

Reference to "one embodiment" or "some embodiments" described in this specification means that a specific characteristic, structure or feature described in combination with this embodiment is included in one or more embodiments of this application. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

With the development of energy storage technologies, a lithium-ion battery is increasingly used in various mobile or fixed devices. To ensure stable running of the devices, a power supply battery needs to be managed, to identify potential risks of the battery in advance, and perform maintenance in advance to avoid serious consequences. A battery SoH value is an important parameter in a battery management system. It indicates a ratio of a real-time capacity to a rated capacity of the battery, and is generally expressed in percentage. The battery SoH value can only be obtained by performing a full charge test or a full discharge test on the battery. However, due to a plurality of factors such as safety, the battery cannot be fully charged and discharged. Therefore, the battery SoH value cannot be accurately measured.

Currently, a method widely used in the industry is to establish a relationship between a battery retention capacity and an online detection parameter, and estimate the battery SoH value by using a charge/discharge curve. However, the method needs to first obtain an aging model through a prior aging test that requires a heavy workload and a long period. In addition, in a plurality of power backup scenarios, for example, in scenarios such as a data center and a station backup power supply, the battery is in a float charging state for long time, and a voltage and a current almost remain unchanged. The foregoing method for estimating the battery SoH value based on the charge/discharge curve cannot be performed. Therefore, an energy storage system in the power backup scenario cannot update the SoH value. In this case, the SoH value needs to be updated through periodic inspection to perform deep charging and discharging. This increases operation and management costs.

Based on this, this application provides an energy storage apparatus, a method for obtaining a battery state of health value, and a battery management system, so that a battery SoH value can be accurately obtained in a plurality of application scenarios, especially in an application scenario, for example, a data center, a station backup power supply, an in-vehicle field, or a photovoltaic power supply, in which a battery is in a float charging state or a shallow charging and shallow discharging state for long time, to identify a battery capacity abnormality risk in advance, and improve stability of the energy storage system.

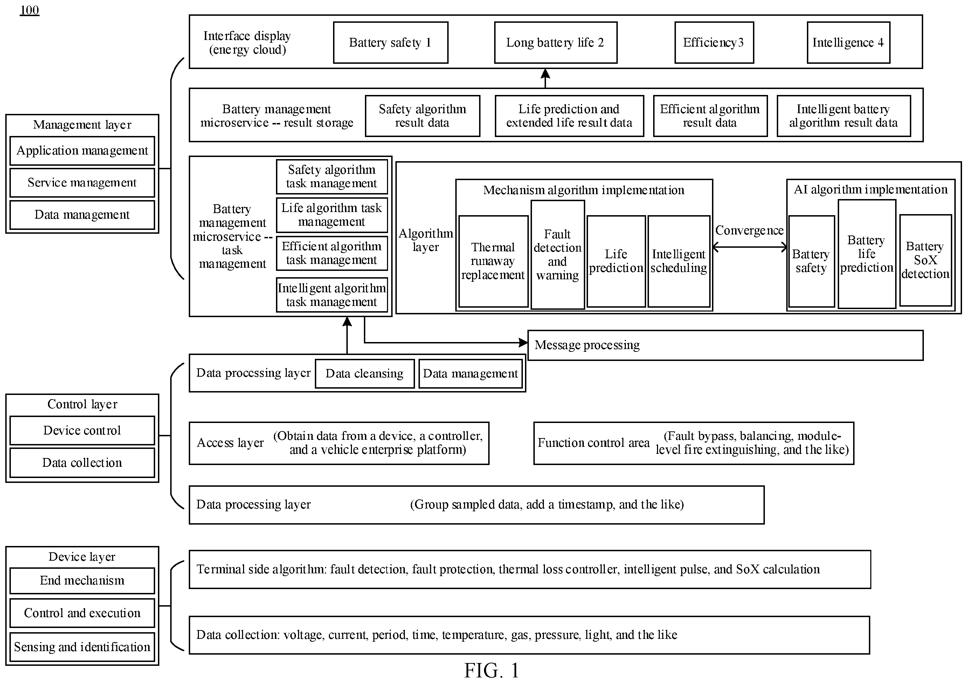

FIG. 1 shows an example application scenario of this application. As shown in FIG. 1, a scenario 100 is a cloud battery management system (battery management system, BMS), which is referred to as a cloud BMS for short. The scenario includes a BMS of a terminal product, a BMS of an energy storage system, and a BMS of an electric vehicle. The BMS is an important link between a battery and the terminal product, the energy storage system, and the electric vehicle. Main functions of the BMS include real-time monitoring of a battery physical parameter, battery state estimation, online diagnosis and warning, energy management, balancing management, and heat management. The cloud BMS that is based on the BMS develops cloud-edge synergy to implement real-time data collection, analysis, state diagnosis, and evaluation of a battery system, and data cleansing and pre-processing. A corresponding algorithm is deployed on the cloud, and a battery running status and a security status are evaluated in a more detailed and comprehensive manner based on more board data. Compared with a traditional board BMS, the cloud BMS has the following advantages.

(1) The cloud can store a large amount of data for analysis.
(2) The cloud has more powerful computing capabilities and can deploy more complex algorithms.
(3) The cloud can perform vertical comparison of data and view the time.
(4) The cloud can compare different cells horizontally.
(5) The cloud can incorporate more external information for judgment.

A cloud BMS productization framework may be as follows: At a device layer, a battery terminal (such as an in-vehicle device and an energy storage device) and a control layer upload terminal side data to a cloud platform. The cloud platform parses the data and distributes the data to a mechanism algorithm and an artificial intelligence (artificial intelligence, AI) algorithm. An algorithm module returns a calculation result to an energy cloud platform, displays the result on a terminal side, and finally feeds back an analysis conclusion to a battery system maintenance personnel for maintenance and management operations.

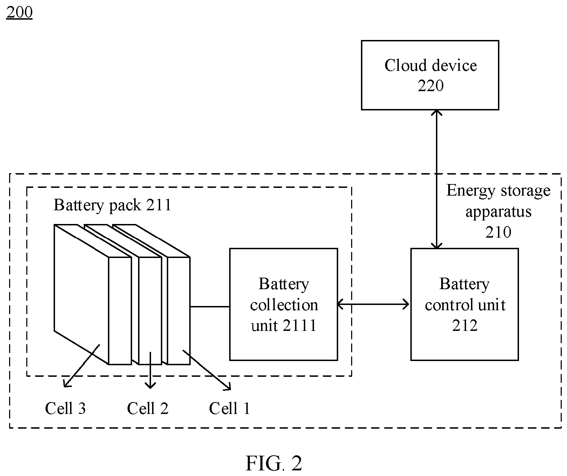

FIG. 2 is a schematic diagram of a structure of an energy storage apparatus according to an embodiment of this application. As shown in FIG. 2, an energy storage apparatus 210 includes a battery control unit BCU 212 and at least one battery pack 211. The battery pack 211 includes a battery monitor unit BMU 2111 and a plurality of cells (for example, a cell 1, a cell 2, and a cell 3), and the plurality of cells are connected in series. The battery control unit BCU 212 is connected to at least one battery pack 211, and the battery monitor unit BMU 2111 is connected to a first cell of the plurality of cells, where the first cell may be one or more of the cell 1, the cell 2, and the cell 3. The battery control unit BCU 212 is configured to receive a battery state of health SoH value estimation model from a cloud device 220, where the battery SoH value estimation model is obtained by the cloud device 220 through training based on historical equivalent circuit model parameters of the plurality of cells and historical actual SoH values of the plurality of cells, equivalent circuit model parameters of the plurality of cells include at least one of equivalent inductance parameters, equivalent capacitance parameters, and equivalent resistance parameters of the plurality of cells, and the historical equivalent circuit model parameters of the plurality of cells one-to-one correspond to the historical actual SoH values of the plurality of cells. The battery monitor unit BMU 2111 is configured to obtain a real-time equivalent circuit model parameter of the first cell, and obtain an estimated SoH value of the first cell based on the real-time equivalent circuit model parameter of the first cell and the battery SoH value estimation model.

In this embodiment of this application, the battery monitor unit BMU 2111 is further configured to send an alternating current excitation electrical signal to the first cell, and obtain a sampling signal from the first cell, where the sampling signal is used to obtain the real-time equivalent circuit model parameter of the first cell. The sampling signal includes at least one of voltage information, current information, and temperature information that are of the first cell. A frequency of the alternating current excitation electrical signal is a preset value. For example, a frequency range of the alternating current excitation electrical signal may be any value between 0.001 Hz and 1 MHz or any frequency range. The alternating current excitation electrical signal may be a voltage excitation signal or a current excitation signal. This is not limited in this application.

Optionally, in this embodiment of this application, when sending the alternating current excitation electrical signal to the first cell, the battery monitor unit BMU 2111 may send an alternating current excitation electrical signal of a single frequency at a time, or may superimpose alternating current excitation electrical signals of a plurality of frequencies, and send the alternating current excitation electrical signals to the first cell at the same time. A waveform of the alternating current excitation electrical signal may be any one of a sine wave, a square wave, and a triangular wave, or any combination of a sine wave, a square wave, and a triangular wave.

In this embodiment of this application, a frequency at which the battery monitor unit BMU 2111 obtains the sampling signal from the first cell is $f_1$, a frequency at which the battery monitor unit BMU 2111 sends the alternating current excitation electrical signal to the first cell is $f_2$, and $f_1$ and $f_2$ meet: $f_1 \geq 2f_2$. In this way, a sampling frequency is twice or more than a frequency of sending the alternating current excitation electrical signal, so that a change of the sampling signal after the alternating current excitation electrical signal is applied can be accurately learned, and a circuit model parameter of a cell can be parsed from the sampling signal.

Optionally, the battery control unit BCU 212 is further configured to send the historical equivalent circuit model parameters of the plurality of cells and the historical actual SoH values of the plurality of cells to the cloud device 220. The historical equivalent circuit model parameters of the plurality of cells and the historical actual SoH values of the plurality of cells are used by the cloud device to perform model training, to obtain the battery SoH value estimation model.

Optionally, the battery control unit BCU 212 is further configured to send, to the cloud device 220, the real-time equivalent circuit model parameter of the first cell and an actual SoH value that is of the first cell and that corresponds to the real-time equivalent circuit model parameter of the first cell, where the real-time equivalent circuit model parameter of the first cell and the actual SoH value that is of the first cell and that corresponds to the real-time equivalent circuit model parameter of the first cell are used by the cloud device to update the battery SoH value estimation model, to obtain an updated battery SoH value estimation model. In this way, in use of the battery SoH value estimation model, continuous iteration may be performed based on an actual SoH value of a cell and an estimated SoH value of the cell, thereby improving precision of the battery SoH value estimation model.

Optionally, the battery control unit BCU 212 is further configured to receive an updated battery SoH value estimation model from the cloud device 220.

According to the energy storage apparatus disclosed in this application, a battery SoH value is estimated by using an artificial intelligence model, and deep charging and discharging do not need to be performed on the battery, so that the battery SoH value can be accurately obtained in a plurality of application scenarios, and a battery capacity abnormality risk can be identified in advance, thereby improving stability of an energy storage system.

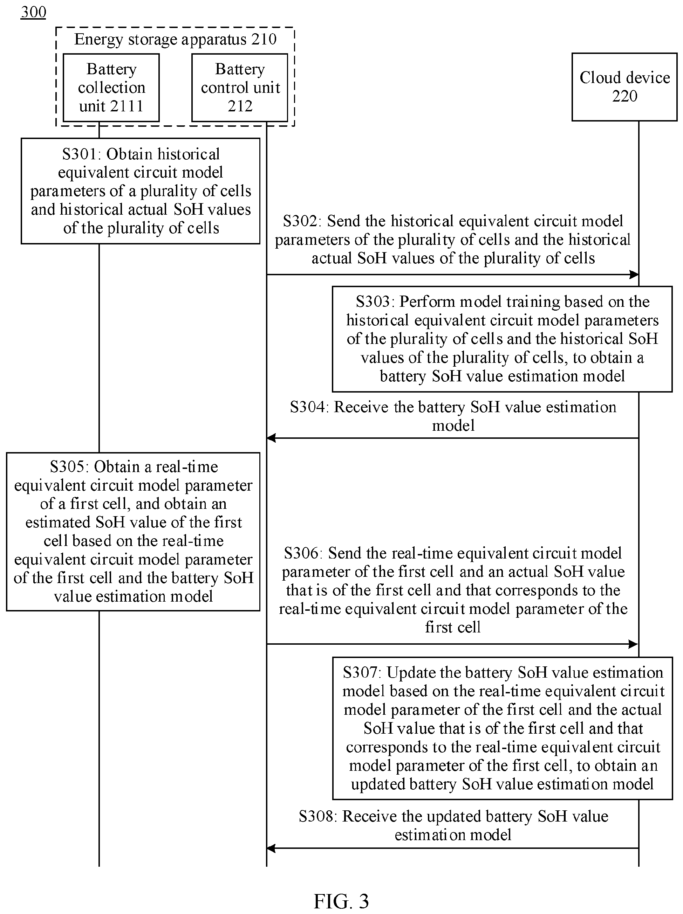

FIG. 3 is a schematic diagram of interaction between an energy storage apparatus 210 and a cloud device 220 according to an embodiment of this application. As shown in FIG. 3, the energy storage apparatus includes a battery monitor unit BMU 2111 and a battery control unit BCU 212. Interaction between the energy storage apparatus 210 and the cloud device 220 may be shown as follows.

S301: The battery monitor unit BMU 2111 obtains historical equivalent circuit model parameters of a plurality of cells and historical actual SoH values of the plurality of cells.

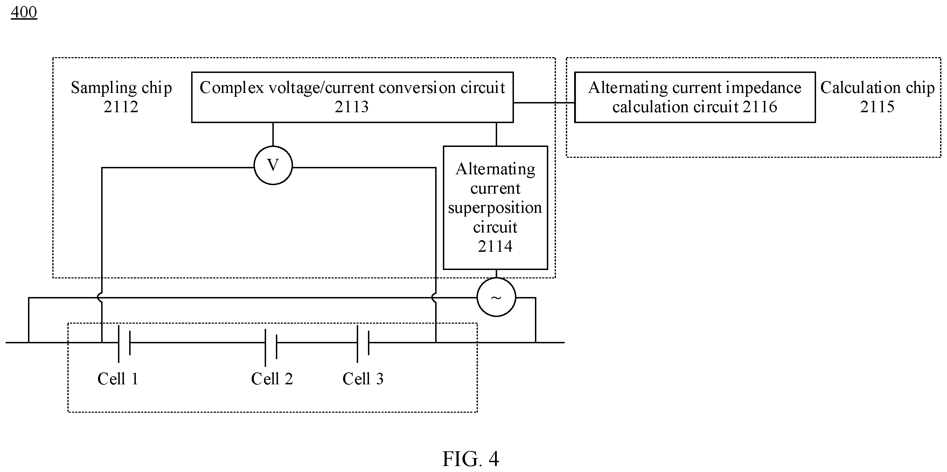

The battery monitor unit BMU 2111 may obtain the historical equivalent circuit model parameters of the cells in a manner of sending an alternating current excitation electrical signal to the plurality of cells, and then obtaining a plurality of sampling signals from the cells. In actual use of these cells, the historical actual SoH values of the cells are obtained based on deep charging and discharging conditions of the cells (or batteries). Specifically, as shown in FIG. 4, the battery monitor unit BMU 2111 may include a sampling chip 2112 and a calculation chip 2115. The sampling chip 2112 specifically includes a complex voltage/current conversion circuit 2113 and an alternating current superposition circuit 2114. The calculation chip 2115 includes an alternating current impedance calculation circuit 2116. The battery pack 211 includes a cell 1, a cell 2, and a cell 3. The plurality of cells are the cell 1, the cell 2, and the cell 3 are used an example. The alternating current superposition circuit 2114 is configured to send an alternating current excitation electrical signal to the cell 1, the cell 2, and the cell 3, and the complex voltage/current conversion circuit 2113 is configured to obtain a plurality of sampling signals and the alternating current excitation electrical signal sent by the alternating current superposition circuit 2114. The calculation chip 2115 parses, by using the alternating current impedance calculation circuit 2116, the plurality of sampling signals and the alternating current excitation electrical signal sent by the alternating current superposition circuit 2114, to obtain historical equivalent circuit model parameters of the cell 1, the cell 2, and the cell 3.

Specifically, when sending the alternating current excitation electrical signals to the cell 1, the cell 2, and the cell 3, the alternating current superposition circuit 2114 may send an alternating current excitation electrical signal of a single frequency at a time, or may superimpose alternating current excitation electrical signals of a plurality of frequencies, and then send the alternating current excitation electrical signals to the cell 1, the cell 2, and the cell 3 at the same time. A frequency of the alternating current excitation electrical signal is a preset value. For example, a frequency range of the alternating current excitation electrical signal may be any value between 0.001 Hz and 1 MHz or any frequency range. The alternating current excitation electrical signal may be a voltage excitation signal or a current excitation signal. This is not limited in this application. A waveform of the alternating current excitation electrical signal may be any one of a sine wave, a square wave, and a triangular wave, or any combination of a sine wave, a square wave, and a triangular wave. The plurality of sampling signals include at least one of voltage information, current information, and temperature information that are of the cell 1, the cell 2, and the cell 3. The alternating current impedance calculation circuit 2116 is configured to parse the plurality of sampling signals and the alternating current excitation signal to obtain impedance spectrum information of the cell 1, the cell 2, and the cell 3, and obtain the equivalent circuit model parameters of the cell 1, the cell 2, and the cell 3 based on the impedance spectrum information of the cell 1, the cell 2, and the cell 3 and a preconfigured battery equivalent circuit model. The battery equivalent circuit model is preconfigured or stored in the calculation chip 2115, or the battery equivalent circuit model is stored in another unit or module that can be obtained by the calculation chip 2115.

Optionally, a frequency at which the complex voltage/current conversion circuit 2113 obtains the plurality of sampling signals from the cell 1, the cell 2, and the cell 3 is $f_1$, and a frequency at which the alternating current superposition circuit 2114 sends the alternating current excitation electrical signal to the cell 1, the cell 2, and the cell 3 is $f_2$, and $f_1$ and $f_2$ meet: $f_1 \geq 2f_2$. In this way, a sampling frequency is twice or more than a frequency of sending the alternating current excitation electrical signal, so that a change of the sampling signal after the alternating current excitation electrical signal is applied can be accurately learned, and a circuit model parameter of a cell can be parsed from the sampling signal.

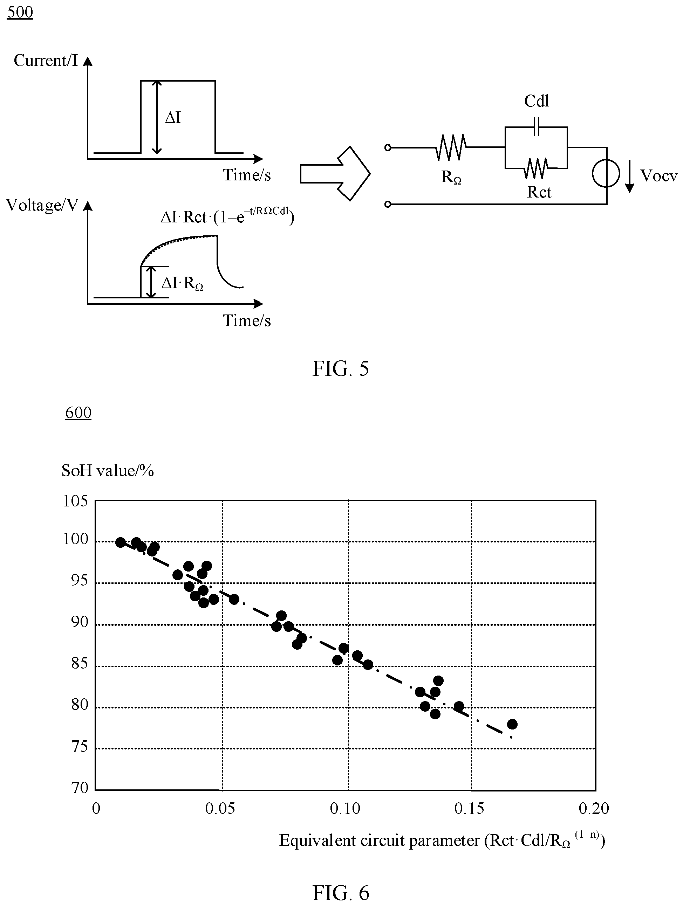

For example, a schematic working diagram of the alternating current impedance calculation circuit 2115 may be shown in FIG. 5. By analyzing a measured voltage signal and a measured circuit signal, various parameters of internal equivalent circuit models of the cell 1, the cell 2, and the cell 3 may be obtained. For example, an equivalent circuit model shown in FIG. 5 is a first-order equivalent circuit model, which may include three parameters: a first resistor $R_\Omega$, a second resistor $R_{ct}$, and a capacitor $C_{dl}$. A voltage response excitation signal and a current response excitation signal are obtained by applying the alternating current excitation electrical signal to the cell 1, the cell 2, and the cell 3. By analyzing a relationship between the alternating current voltage excitation signal and the response excitation signal, internal equivalent circuit model parameters of the cell 1, the cell 2, and the cell 3 are obtained. For example, $R_\Omega$ may be obtained through calculation by analyzing instantaneous voltage rise, and the second resistor $R_{ct}$ and the capacitor $C_{dl}$ may be obtained by using a relaxation voltage drop of a period of time after instantaneous voltage drop, and the equivalent circuit model parameters of the cell 1, the cell 2, and the cell 3 are finally obtained.

As shown in FIG. 6, when a cell ages, an internal material and a structure of the cell change, and these changes are reflected in an equivalent circuit model parameter of the cell. Therefore, by analyzing the change of the equivalent circuit model parameter, an aging degree of the cell can be represented, that is, battery SoH estimation can be implemented.

S302: The battery control unit BCU 212 sends the historical equivalent circuit model parameters of the plurality of cells and the historical actual SoH values of the plurality of cells to the cloud device 220.

Correspondingly, the cloud device 220 receives the historical equivalent circuit model parameters of the plurality of cells and the historical actual SoH values of the plurality of cells from the battery control unit BCU 212.

In actual use of a battery, a cause of capacity attenuation of the battery is usually a result of coupling of a plurality of factors. Calculation workload to obtain a relationship between an estimated battery SoH value and variables based on corresponding manually-fitting parameters is heavy, and it is difficult to have a correct expression. Therefore, in this embodiment of this application, the battery control unit BCU 212 in the energy storage apparatus 210 may upload, to the cloud device 220, the cell equivalent circuit model parameter obtained by the battery monitor unit BMU 2111 based on the sampling signal and the alternating current excitation electrical signal. The cloud device 220 establishes a relationship between the battery equivalent circuit model parameter and the battery SoH value by using an AI big data analysis method.

S303: The cloud device 220 performs model training based on the historical equivalent circuit model parameters of the plurality of cells and the historical SoH values of the plurality of cells, to obtain the battery SoH value estimation model.

Specifically, the cloud device performs big data online training based on the historical equivalent circuit model parameters of the plurality of cells and the historical SoH values of the plurality of cells, and outputs a correlation relationship between the equivalent circuit model parameters of the cells and the SoH values of the cells, that is, the battery SoH value estimation model, by using comparison of historical features of a single cell and horizontal comparison of a plurality of cells.

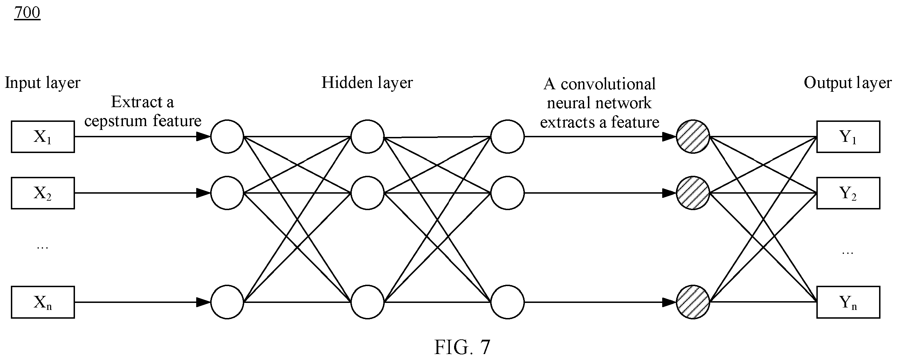

For example, a process in which the cloud device 220 performs model training to obtain the battery SoH value estimation model may be shown in FIG. 7. Input parameters $X_1$ and $X_2$ of an input layer may be historical equivalent circuit model parameters of the cell 1, the cell 2, and the cell 3. After a cepstrum feature is extracted from the input parameter, the cepstrum feature is input to a hidden layer for big data online training. Training is performed by using comparison of historical features of a single cell and horizontal comparison of a plurality of cells. A feature is extracted by using a convolutional neural network. Output parameters $Y_1$, $Y_2$, and the like of an output layer may be estimated SoH values of the cell 1, the cell 2, and the cell 3. The battery SoH value estimation model obtained through model training of the cloud device 220 can output an estimated SoH value of a cell based on an equivalent circuit model parameter of any cell.

S304: The battery control unit BCU 212 receives a battery SoH value estimation model from the cloud device 220.

Correspondingly, the cloud device 220 sends the battery SoH value estimation model to the battery control unit BCU 212.

S305: The battery monitor unit BMU 2111 obtains a real-time equivalent circuit model parameter of the first cell, and obtains an estimated SoH value of the first cell based on the real-time equivalent circuit model parameter of the first cell and the battery SoH value estimation model.

The first cell may be one or more of the cell 1, the cell 2, and the cell 3. For a process that the battery monitor unit BMU 2111 obtains the real-time equivalent circuit model parameter of the first cell, refer to the process shown in FIG. 4. Details are not described herein again. It should be noted that, the battery monitor unit BMU 2111 obtains the real-time equivalent circuit model parameter of the first cell by using the sampling signal. In this way, accuracy of data can be ensured, thereby improving accuracy of the obtained estimated SoH value.

Optionally, after obtaining the estimated SoH value corresponding to the real-time equivalent circuit model parameter of the first cell, the battery monitor unit BMU 2111 may display the estimated SoH value on a battery terminal, so that an operation and maintenance personnel observes, maintains, and manages the battery.

S306: The battery control unit BCU 212 is further configured to send, to the cloud device 220, the real-time equivalent circuit model parameter of the first cell and an actual SoH value corresponding to the real-time equivalent circuit model parameter of the first cell.

Correspondingly, the cloud device 220 receives, from the battery control unit BCU 212, the real-time equivalent circuit model parameter of the first cell and the actual SoH value corresponding to the real-time equivalent circuit model parameter of the first cell.

The actual SoH value corresponding to the real-time equivalent circuit model parameter of the first cell refers to an SoH value obtained by performing deep charging and discharging of the first cell in actual use, and is different from an estimated SoH value obtained by using the battery SoH value estimation model.

S307: The cloud device 220 updates the battery SoH value estimation model based on the real-time equivalent circuit model parameter of the first cell and the actual SoH value corresponding to the real-time equivalent circuit model parameter of the first cell, to obtain an updated battery SoH value estimation model.

Specifically, the cloud device 220 continuously performs continuous iteration based on the estimated SoH value obtained by the battery monitor unit BMU 2111 in a process of using the model and the actual SoH value obtained by deep charging and discharging in a process of using the cell, to update the battery SoH value estimation model, to improve precision of the battery SoH value estimation model. For a continuous iteration process, refer to the conventional technology. Details are not described herein again.

S308: The battery control unit BCU receives the updated battery SoH value estimation model from the cloud device 220.

Correspondingly, the cloud device 220 sends the updated battery SoH value estimation model to the battery control unit BCU 212.

According to the energy storage apparatus disclosed in this application, a battery SoH value is estimated by using an artificial intelligence model, and deep charging and discharging do not need to be performed on the battery, so that the battery SoH value can be accurately obtained in a plurality of application scenarios, and a battery capacity

English translation abnormality risk can be identified in advance, thereby improving stability of an energy storage system. In addition, the energy storage apparatus and the cloud device disclosed in this application can further obtain continuous iteration of an actual battery SoH value with reference to a deep charge/discharge usage state in actual use, thereby improving model precision.

An embodiment of this application further provides a battery management system. The battery management system includes the energy storage apparatus and the cloud device described above. The energy storage apparatus includes at least one battery pack, where the battery pack includes a plurality of cells, the plurality of cells are connected in series, and the plurality of cells include a first cell. Optionally, the battery management system may further include another device that communicates with the energy storage device or the cloud device.

In embodiments provided in this application, it should be understood that the disclosed system, apparatus, and method may be implemented in other manners. The described apparatus embodiment is merely an example. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of embodiments.

In addition, functional units in embodiments of this application may be integrated into one processing unit, each of the units may exist alone physically, or two or more units are integrated into one unit.

When the functions are implemented in the form of a software functional unit and sold or used as an independent product, the functions may be stored in a computer-readable storage medium. Based on such an understanding, the technical solutions of this application essentially, or the part contributing to the prior art, or some of the technical solutions may be implemented in a form of a software product. The software product is stored in a storage medium, and includes several instructions for instructing a computer device (which may be a personal computer, a server, or a network device) to perform all or some of the steps of the methods described in the embodiments of this application. The foregoing storage medium includes any medium that can store program code, such as a USB flash drive, a removable hard disk, a read-only memory (read-only memory, ROM), a random access memory (random access memory, RAM), a magnetic disk, or an optical disc.

The foregoing descriptions are merely specific implementations of this application, but are not intended to limit the protection scope of this application. Therefore, the protection scope of this application shall be subject to the protection scope of the claims.

## Claims

1. An energy storage apparatus (210),

wherein the energy storage apparatus comprises a battery control unit BCU (212) and at least one battery pack (211), the battery pack comprises a battery monitor unit BMU (2111) and a plurality of cells, the plurality of cells are connected in series, the battery control unit BCU is connected to the at least one battery pack, and the battery monitor unit BMU is connected to a first cell of the plurality of cells;
the battery control unit BCU is configured to receive a battery state of health SoH value estimation model from a cloud device (220), wherein the battery SoH value estimation model is obtained by the cloud device through training based on historical equivalent circuit model parameters of the plurality of cells and historical actual SoH values of the plurality of cells, equivalent circuit model parameters of the plurality of cells comprise at least one of equivalent inductance parameters, equivalent capacitance parameters, and equivalent resistance parameters of the plurality of cells, and the historical equivalent circuit model parameters of the plurality of cells one-to-one correspond to the historical actual SoH values of the plurality of cells; and
the battery monitor unit BMU is configured to obtain a real-time equivalent circuit model parameter of the first cell, and obtain an estimated SoH value of the first cell based on the real-time equivalent circuit model parameter of the first cell and the battery SoH value estimation model.

2. The energy storage apparatus according to claim 1, wherein the battery monitor unit BMU is further configured to:

send an alternating current excitation electrical signal to the first cell, wherein a frequency of the alternating current excitation electrical signal is a preset value; and
obtain a sampling signal from the first cell, wherein the sampling signal is used to obtain the real-time equivalent circuit model parameter of the first cell, and the sampling signal comprises at least one of voltage information, current information, and temperature information that are of the first cell.

3. The energy storage apparatus according to claim 2, wherein a frequency at which the battery monitor unit BMU obtains the sampling signal from the first cell is $f_1$, a frequency at which the battery monitor unit BMU sends the alternating current excitation electrical signal to the first cell is $f_2$, and $f_1$ and $f_2$ meet:

$$f_1 \geq 2 f_2 .$$

4. The energy storage apparatus according to any one of claims 1 to 3, wherein the battery monitor unit BMU is specifically configured to:

parse the sampling signal and the alternating current excitation signal to obtain impedance spectrum information of the first cell; and obtain the real-time equivalent circuit model parameter of the first cell based on the impedance spectrum information of the first cell and a battery equivalent circuit model, wherein the battery equivalent circuit model is preconfigured or stored in the battery monitor unit BMU.

5. The energy storage apparatus according to any one of claims 1 to 4, wherein the battery control unit BCU is further configured to:
send the historical equivalent circuit model parameters of the plurality of cells and the historical actual SoH values of the plurality of cells to the cloud device.

6. The energy storage apparatus according to any one of claims 1 to 5, wherein the battery control unit BCU is further configured to:
send, to the cloud device, the real-time equivalent circuit model parameter of the first cell and an actual SoH value that is of the first cell and that corresponds to the real-time equivalent circuit model parameter of the first cell, wherein the real-time equivalent circuit model parameter of the first cell and the actual SoH value that is of the first cell and that corresponds to the real-time equivalent circuit model parameter of the first cell are used by the cloud device to update the battery SoH value estimation model, to obtain an updated battery SoH value estimation model.

7. The energy storage apparatus according to any one of claims 1 to 6, wherein the battery control unit BCU is further configured to:
receive the updated battery SoH value estimation model from the cloud device.

8. The energy storage apparatus according to any one of claims 2 to 7, wherein a waveform of the alternating current excitation electrical signal comprises at least one of a sine wave, a square wave, or a triangular wave.

9. A method for obtaining a battery state of health SoH value, wherein the method is executed by an energy storage apparatus (210), the energy storage apparatus comprises at least one battery pack (211), the battery pack comprises a plurality of cells, the plurality of cells are connected in series, and the plurality of cells comprise a first cell; and the method comprises:

receiving a battery SoH value estimation model from a cloud device (220), wherein the battery SoH value estimation model is obtained by the cloud device through training based on historical equivalent circuit model parameters of the plurality of cells and historical actual SoH values of the plurality of cells, equivalent circuit model parameters of the plurality of cells comprise at least one of equivalent inductance parameters, equivalent capacitance parameters, and equivalent resistance parameters of the plurality of cells, and the historical equivalent circuit model parameters of the plurality of cells one-to-one correspond to the historical actual SoH values of the plurality of cells; and obtaining a real-time equivalent circuit model parameter of the first cell, and obtaining an estimated SoH value of the first cell based on the real-time equivalent circuit model parameter of the first cell and the battery SoH value estimation model.

10. The method according to claim 9, wherein the method further comprises:

sending an alternating current excitation electrical signal to the first cell, wherein a frequency of the alternating current excitation electrical signal is a preset value; obtaining a sampling signal from the first cell, wherein the sampling signal comprises at least one of voltage information, current information, and temperature information that are of the first cell; and the obtaining a real-time equivalent circuit model parameter of the first cell comprises:

parsing the sampling signal and the alternating current excitation signal to obtain impedance spectrum information of the first cell; and obtaining the real-time equivalent circuit model parameter of the first cell based on the impedance spectrum information of the first cell and a battery equivalent circuit model, wherein the battery equivalent circuit model is preconfigured or stored in the battery monitor unit BMU.

11. The method according to claim 9 or 10, wherein the method further comprises:
sending the historical equivalent circuit model parameters of the plurality of cells and the historical actual SoH values of the plurality of cells to the cloud device.

12. The method according to any one of claims 9 to 11, wherein the method further comprises:
sending, to the cloud device, the real-time equivalent circuit model parameter of the first cell and an actual SoH value that is of the first cell and that corresponds to the real-time equivalent circuit model parameter of the first cell, wherein the real-time equivalent circuit model parameter of the first cell and the actual SoH value that is of the first cell and that corresponds to the real-time equivalent circuit model parameter of the first cell are used by the cloud device to update the battery SoH value estimation model, to obtain an updated battery SoH value estimation model.

13. The method according to any one of claims 9 to 12, wherein the method further comprises:
receiving the updated battery SoH value estimation model from the cloud device.

14. A battery management system (100),

wherein the system comprises an energy storage apparatus (210) and a cloud device (220), the energy storage apparatus comprises at least one battery pack (211), the battery pack comprises a plurality of cells, the plurality of cells are connected in series, and the plurality of cells comprise a first cell;
the cloud device is configured to send a battery state of health SoH value estimation model to the energy storage apparatus, wherein the battery SoH value estimation model is obtained by the cloud device through training based on historical equivalent circuit model parameters of the plurality of cells and historical actual SoH values of the plurality of cells, equivalent circuit model parameters of the plurality of cells comprise at least one of equivalent inductance parameters, equivalent capacitance parameters, and equivalent resistance parameters of the plurality of cells, and the historical equivalent circuit model parameters of the plurality of cells one-to-one correspond to the historical actual SoH values of the plurality of cells; and
the energy storage apparatus is configured to obtain a real-time equivalent circuit model parameter of the first cell, and obtain an estimated SoH value of the first cell based on the real-time equivalent circuit model parameter of the first cell and the battery SoH value estimation model.

15. The system according to claim 14, wherein the energy storage apparatus is further configured to send the real-time equivalent circuit model parameter of the first cell and an actual SoH value that is of the first cell and that corresponds to the real-time equivalent circuit model parameter of the first cell to the cloud device; and
the cloud device is further configured to update the battery SoH value estimation model based on the real-time equivalent circuit model parameter of the first cell and the actual SoH value that is of the first cell and that corresponds to the real-time equivalent circuit model parameter of the first cell, to obtain an updated battery SoH value estimation model.

## Patentansprüche

1. Energiespeichervorrichtung (210), wobei die Energiespeichervorrichtung eine Batteriesteuereinheit, BCU, (212) und mindestens einen Batteriesatz (211) umfasst, der Batteriesatz eine Batterieüberwachungseinheit, BMU, (2111) und eine Vielzahl von Zellen umfasst, die Vielzahl von Zellen in Reihe geschaltet ist, die Batteriesteuereinheit, BCU, mit dem mindestens einen Batteriesatz verbunden ist und die Batterieüberwachungseinheit, BMU, mit einer ersten Zelle der Vielzahl von Zellen verbunden ist;

die Batteriesteuereinheit, BCU, dazu konfiguriert ist, ein Batteriegesundheitszustandswert-Schätzmodell, Batterie-SoH-Wert-Schätzmodell, von einer Cloud-Einrichtung (220) zu empfangen,
wobei das Batterie-SoH-Wert-Schätzmodell durch die Cloud-Einrichtung mittels Training basierend auf historischen äquivalenten Schaltkreismodell-Parametern der Vielzahl von Zellen und historischen tatsächlichen SoH-Werten der Vielzahl von Zellen erlangt wird, äquivalente Schaltkreismodell-Parameter der Vielzahl von Zellen mindestens einen aus äquivalenten Induktivitätsparametern, äquivalenten Kapazitätsparametern und äquivalenten Widerstandsparametern der Vielzahl von Zellen umfassen und die historischen äquivalenten Schaltkreismodell-Parameter der Vielzahl von Zellen eins zu eins den historischen tatsächlichen SoH-Werten der Vielzahl von Zellen entsprechen; und
die Batterieüberwachungseinheit, BMU, dazu konfiguriert ist, einen äquivalenten Echtzeit-Schaltkreismodell-Parameter der ersten Zelle zu erlangen und einen geschätzten SoH-Wert der ersten Zelle basierend auf dem äquivalenten Echtzeit-Schaltkreismodell-Parameter der ersten Zelle und dem Batterie-SoH-Wert-Schätzmodell zu erlangen.

2. Energiespeichervorrichtung nach Anspruch 1, wobei die Batterieüberwachungseinheit, BMU, ferner zu Folgendem konfiguriert ist:

Senden eines elektrischen Wechselstrom-Anregungssignals an die erste Zelle, wobei eine Frequenz des elektrischen Wechselstrom-Anregungssignals ein voreingestellter Wert ist; und Erlangen eines Abtastsignals von der ersten Zelle, wobei das Abtastsignal dazu verwendet wird, den äquivalenten Echtzeit-Schaltkreismodell-Parameter der ersten Zelle zu erlangen, und

das Abtastsignal mindestens eines aus Spannungsinformationen, Strominformationen und Temperaturinformationen, die von der ersten Zelle stammen, umfasst.

3. Energiespeichervorrichtung nach Anspruch 2, wobei eine Frequenz, mit der die Batterieüberwachungseinheit, BMU, das Abtastsignal von der ersten Zelle erlangt, $f_1$ ist, eine Frequenz, mit der die Batterieüberwachungseinheit, BMU, das elektrische Wechselstrom-Anregungssignal an die erste Zelle sendet, $f_2$ ist und $f_1$ und $f_2$ Folgendes erfüllen:

$$f_1 \geq 2 f_2 .$$

4. Energiespeichervorrichtung nach einem der Ansprüche 1 bis 3, wobei die Batterieüberwachungseinheit, BMU, insbesondere zu Folgendem konfiguriert ist:

Parsen des Abtastsignals und des Wechselstrom-Anregungssignals, um Impedanzspektruminformationen der ersten Zelle zu erlangen; und
Erlangen des äquivalenten Echtzeit-Schaltkreismodell-Parameters der ersten Zelle basierend auf den Impedanzspektruminformationen der ersten Zelle und einem äquivalenten Batterie-Schaltkreismodell, wobei
das äquivalente Batterie-Schaltkreismodell vorkonfiguriert oder in der Batterieüberwachungseinheit, BMU, gespeichert ist.

5. Energiespeichervorrichtung nach einem der Ansprüche 1 bis 4, wobei die Batteriesteuereinheit, BCU, ferner zu Folgendem konfiguriert ist:
Senden der historischen äquivalenten Schaltkreismodell-Parameter der Vielzahl von Zellen und der historischen tatsächlichen SoH-Werte der Vielzahl von Zellen an die Cloud-Einrichtung.

6. Energiespeichervorrichtung nach einem der Ansprüche 1 bis 5, wobei die Batteriesteuereinheit, BCU, ferner zu Folgendem konfiguriert ist:
Senden, an die Cloud-Einrichtung, des äquivalenten Echtzeit-Schaltkreismodell-Parameters der ersten Zelle und eines tatsächlichen SoH-Werts, der von der ersten Zelle stammt und der dem äquivalenten Echtzeit-Schaltkreismodell-Parameter der ersten Zelle entspricht, wobei der äquivalente Echtzeit-Schaltkreismodell-Parameter der ersten Zelle und der tatsächliche SoH-Wert, der von der ersten Zelle stammt und der dem äquivalenten Echtzeit-Schaltkreismodell-Parameter der ersten Zelle entspricht, durch die Cloud-Einrichtung dazu verwendet werden, das Batterie-SoH-Wert-Schätzmodell zu aktualisieren, um ein aktualisiertes Batterie-SoH-Wert-Schätzmodell zu erlangen.

7. Energiespeichervorrichtung nach einem der Ansprüche 1 bis 6, wobei die Batteriesteuereinheit, BCU, ferner zu Folgendem konfiguriert ist:
Empfangen des aktualisierten Batterie-SoH-Wert-Schätzmodells von der Cloud-Einrichtung.

8. Energiespeichervorrichtung nach einem der Ansprüche 2 bis 7, wobei eine Wellenform des elektrischen Wechselstrom-Anregungssignals mindestens eine aus einer Sinuswelle, einer Rechteckwelle oder einer Dreieckwelle umfasst.

9. Verfahren zum Erlangen eines Batteriegesundheitszustandswerts, Batterie-SoH-Werts, wobei das Verfahren durch eine Energiespeichervorrichtung (210) ausgeführt wird, die Energiespeichervorrichtung mindestens einen Batteriesatz (211) umfasst, der Batteriesatz eine Vielzahl von Zellen umfasst, die Vielzahl von Zellen in Reihe geschaltet ist und die Vielzahl von Zellen eine erste Zelle umfasst; und wobei das Verfahren Folgendes umfasst:

Empfangen eines Batterie-SoH-Wert-Schätzmodells von einer Cloud-Einrichtung (220), wobei das Batterie-SoH-Wert-Schätzmodell durch die Cloud-Einrichtung mittels Training basierend auf historischen äquivalenten Schaltkreismodell-Parametern der Vielzahl von Zellen und historischen tatsächlichen SoH-Werten der Vielzahl von Zellen erlangt wird, äquivalente Schaltkreismodell-Parameter der Vielzahl von Zellen mindestens einen aus äquivalenten Induktivitätsparametern, äquivalenten Kapazitätsparametern und äquivalenten Widerstandsparametern der Vielzahl von Zellen umfassen und die historischen äquivalenten Schaltkreismodell-Parameter der Vielzahl von Zellen eins zu eins den historischen tatsächlichen SoH-Werten der Vielzahl von Zellen entsprechen; und
Erlangen eines äquivalenten Echtzeit-Schaltkreismodell-Parameters der ersten Zelle und Erlangen eines geschätzten SoH-Werts der ersten Zelle basierend auf dem äquivalenten Echtzeit-Schaltkreismodell-Parameter der ersten Zelle und dem Batterie-SoH-Wert-Schätzmodell.

**10.** Verfahren nach Anspruch 9, wobei das Verfahren ferner Folgendes umfasst:

Senden eines elektrischen Wechselstrom-Anregungssignals an die erste Zelle, wobei eine Frequenz des elektrischen Wechselstrom-Anregungssignals ein voreingestellter Wert ist;
Erlangen eines Abtastsignals von der ersten Zelle, wobei das Abtastsignal mindestens eines aus Spannungsinformationen, Strominformationen und Temperaturinformationen, die von der ersten Zelle stammen, umfasst; und
das Erlangen eines äquivalenten Echtzeit-Schaltkreismodell-Parameters der ersten Zelle Folgendes umfasst:

Parsen des Abtastsignals und des Wechselstrom-Anregungssignals, um Impedanzspektruminformationen der ersten Zelle zu erlangen; und
Erlangen des äquivalenten Echtzeit-Schaltkreismodell-Parameters der ersten Zelle basierend auf den Impedanzspektruminformationen der ersten Zelle und einem äquivalenten Batterie-Schaltkreismodell, wobei das äquivalente Batterie-Schaltkreismodell vorkonfiguriert oder in der Batterieüberwachungseinheit, BMU, gespeichert ist.

**11.** Verfahren nach Anspruch 9 oder 10, wobei das Verfahren ferner Folgendes umfasst:
Senden der historischen äquivalenten Schaltkreismodell-Parameter der Vielzahl von Zellen und der historischen tatsächlichen SoH-Werte der Vielzahl von Zellen an die Cloud-Einrichtung.

**12.** Verfahren nach einem der Ansprüche 9 bis 11, wobei das Verfahren ferner Folgendes umfasst:
Senden, an die Cloud-Einrichtung, des äquivalenten Echtzeit-Schaltkreismodell-Parameters der ersten Zelle und eines tatsächlichen SoH-Werts, der von der ersten Zelle stammt und der dem äquivalenten Echtzeit-Schaltkreismodell-Parameter der ersten Zelle entspricht, wobei der äquivalente Echtzeit-Schaltkreismodell-Parameter der ersten Zelle und der tatsächliche SoH-Wert, der von der ersten Zelle stammt und der dem äquivalenten Echtzeit-Schaltkreismodell-Parameter der ersten Zelle entspricht, durch die Cloud-Einrichtung dazu verwendet werden, das Batterie-SoH-Wert-Schätzmodell zu aktualisieren, um ein aktualisiertes Batterie-SoH-Wert-Schätzmodell zu erlangen.

**13.** Verfahren nach einem der Ansprüche 9 bis 12, wobei das Verfahren ferner Folgendes umfasst:
Empfangen des aktualisierten Batterie-SoH-Wert-Schätzmodells von der Cloud-Einrichtung.

**14.** Batteriemanagementsystem (100), wobei das System eine Energiespeichervorrichtung (210) und eine Cloud-Einrichtung (220) umfasst, die Energiespeichervorrichtung mindestens einen Batteriesatz (211) umfasst, der Batteriesatz eine Vielzahl von Zellen umfasst, die Vielzahl von Zellen in Reihe geschaltet ist und die Vielzahl von Zellen eine erste Zelle umfasst;

die Cloud-Einrichtung dazu konfiguriert ist, ein Batterie-SoH-Wert-Schätzmodell an die Energiespeichervorrichtung zu senden, wobei das Batterie-SoH-Wert-Schätzmodell durch die Cloud-Einrichtung mittels Training basierend auf historischen äquivalenten Schaltkreismodell-Parametern der Vielzahl von Zellen und historischen tatsächlichen SoH-Werten der Vielzahl von Zellen erlangt wird, äquivalente Schaltkreismodell-Parameter der Vielzahl von Zellen mindestens einen aus äquivalenten Induktivitätsparametern, äquivalenten Kapazitätsparametern und äquivalenten Widerstandsparametern der Vielzahl von Zellen umfassen und die historischen äquivalenten Schaltkreismodell-Parameter der Vielzahl von Zellen eins zu eins den historischen tatsächlichen SoH-Werten der Vielzahl von Zellen entsprechen; und
die Energiespeichervorrichtung dazu konfiguriert ist, einen äquivalenten Echtzeit-Schaltkreismodell-Parameter der ersten Zelle zu erlangen und einen geschätzten SoH-Wert der ersten Zelle basierend auf dem äquivalenten Echtzeit-Schaltkreismodell-Parameter der ersten Zelle und dem Batterie-SoH-Wert-Schätzmodell zu erlangen.

**15.** System nach Anspruch 14, wobei die Energiespeichervorrichtung ferner dazu konfiguriert ist, den äquivalenten Echtzeit-Schaltkreismodell-Parameter der ersten Zelle und einen tatsächlichen SoH-Wert, der von der ersten Zelle stammt und der dem äquivalenten Echtzeit-Schaltkreismodell-Parameter der ersten Zelle entspricht, an die Cloud-Einrichtung zu senden; und
die Cloud-Einrichtung ferner dazu konfiguriert ist, das Batterie-SoH-Wert-Schätzmodell basierend auf dem äquivalenten Echtzeit-Schaltkreismodell-Parameter der ersten Zelle und dem tatsächlichen SoH-Wert, der von der ersten Zelle stammt und der dem äquivalenten Echtzeit-Schaltkreismodell-Parameter der ersten Zelle entspricht, zu aktualisieren, um ein aktualisiertes Batterie-SoH-Wert-Schätzmodell zu erlangen.

**Revendications**

**1.** Appareil de stockage d'énergie (210), dans lequel l'appareil de stockage d'énergie comprend une unité de commande de batterie BCU (212) et au moins un bloc-batterie (211), le bloc-batterie comprend une unité de surveillance de batterie BMU (2111) et une pluralité de cellules, la pluralité de cellules sont connectées en série, l'unité de commande de batterie BCU est connectée au moins à un bloc-batterie, et l'unité de surveillance de batterie BMU est connectée à une première cellule de la pluralité de cellules ;

l'unité de commande de batterie BCU est configurée pour recevoir un modèle d'estimation de la valeur de l'état de santé, SoH, de la batterie à partir d'un dispositif en nuage (220),
dans lequel le modèle d'estimation de la valeur SoH de la batterie est obtenu par le dispositif en nuage grâce à un entraînement basé sur les paramètres historiques du modèle de circuit équivalent de la pluralité de cellules et les valeurs SoH historiques réelles de la pluralité de cellules, les paramètres du modèle de circuit équivalent de la pluralité de cellules comprennent au moins l'un des paramètres d'inductance équivalents, des paramètres de capacité équivalents et des paramètres de résistance équivalents de la pluralité de cellules, et les paramètres historiques du modèle de circuit équivalent de la pluralité de cellules correspondent un à un aux valeurs SoH historiques réelles de la pluralité de cellules ; et
l'unité de surveillance de batterie BMU est configurée pour obtenir un paramètre de modèle de circuit équivalent en temps réel de la première cellule, et obtenir une valeur SoH estimée de la première cellule sur la base du paramètre de modèle de circuit équivalent en temps réel de la première cellule et du modèle d'estimation de la valeur SoH de la batterie.

2. Appareil de stockage d'énergie selon la revendication 1, dans lequel l'unité de surveillance de batterie (BMU) est également configurée pour :

envoyer un signal électrique d'excitation de courant alternatif à la première cellule, dans lequel la fréquence du signal électrique d'excitation de courant alternatif est une valeur prédéfinie ; et
obtenir un signal d'échantillonnage à partir de la première cellule, dans lequel le signal d'échantillonnage est utilisé pour obtenir le paramètre de modèle de circuit équivalent en temps réel de la première cellule, et le signal d'échantillonnage comprend au moins l'une des informations de tension, des informations de courant et des informations de température qui sont de la première cellule.

3. Appareil de stockage d'énergie selon la revendication 2, dans lequel la fréquence à laquelle l'unité de surveillance de batterie, BMU, obtient le signal d'échantillonnage de la première cellule est $f_1$, la fréquence à laquelle l'unité de surveillance de batterie, BMU, envoie le signal électrique d'excitation en courant alternatif à la première cellule est $f_2$, et $f_1$ et $f_2$ sont égales à :

$$f_1 \geq 2\,f_2 .$$

4. Appareil de stockage d'énergie selon l'une quelconque des revendications 1 à 3, dans lequel l'unité de surveillance de batterie, BMU, est spécifiquement configurée pour :

analyser le signal d'échantillonnage et le signal d'excitation à courant alternatif pour obtenir des informations sur le spectre d'impédance de la première cellule ; et
obtenir le paramètre de modèle de circuit équivalent en temps réel de la première cellule sur la base des informations du spectre d'impédance de la première cellule et d'un modèle de circuit équivalent de batterie, dans lequel
le modèle de circuit équivalent de batterie est préconfiguré ou stocké dans l'unité de surveillance de batterie BMU.

5. Appareil de stockage d'énergie selon l'une quelconque des revendications 1 à 4, dans lequel l'unité de commande de batterie BCU est également configurée pour :
envoyer les paramètres historiques du modèle de circuit équivalent de la pluralité de cellules et les valeurs SoH historiques réelles de la pluralité de cellules au dispositif en nuage.

6. Appareil de stockage d'énergie selon l'une quelconque des revendications 1 à 5, dans lequel l'unité de commande de batterie BCU est également configurée pour :
envoyer, au dispositif en nuage, le paramètre de modèle de circuit équivalent en temps réel de la première cellule et une valeur SoH réelle qui est de la première cellule et qui correspond au paramètre de modèle de circuit équivalent en temps réel de la première cellule, dans lequel le paramètre de modèle de circuit équivalent en temps réel de la première cellule et la valeur SoH réelle qui est de la première cellule et qui correspond au paramètre de modèle de circuit équivalent en temps réel de la première cellule sont utilisés par le dispositif en nuage pour mettre à jour le modèle d'estimation de valeur SoH de la batterie, pour obtenir un modèle d'estimation de valeur SoH de la batterie mis à jour.

7. Appareil de stockage d'énergie selon l'une quelconque des revendications 1 à 6, dans lequel l'unité de commande de batterie BCU est également configurée pour :

recevoir le modèle d'estimation de la valeur SoH de la batterie mis à jour à partir du dispositif en nuage.

8. Appareil de stockage d'énergie selon l'une quelconque des revendications 2 à 7, dans lequel une forme d'onde du signal électrique d'excitation de courant alternatif comprend au moins l'une d'une onde sinusoïdale, d'une onde carrée ou d'une onde triangulaire.

9. Procédé d'obtention d'état de batterie de valeur SoH, dans lequel le procédé est exécuté par un appareil de stockage d'énergie (210), l'appareil de stockage d'énergie comprend au moins un bloc-batterie (211), le bloc-batterie comprend une pluralité de cellules, la pluralité de cellules sont connectées en série, et la pluralité de cellules comprennent une première cellule ; et
le procédé comprend :

la réception d'un modèle d'estimation d'état de batterie de valeur SoH à partir du dispositif en nuage (220), dans lequel le modèle d'estimation d'état de batterie de valeur SoH est obtenu par le dispositif en nuage grâce à un entraînement basé sur les paramètres historiques du modèle de circuit équivalent de la pluralité de cellules et les valeurs SoH historiques réelles de la pluralité de cellules, les paramètres du modèle de circuit équivalent de la pluralité de cellules comprennent au moins l'un des paramètres d'inductance équivalents, des paramètres de capacité équivalents et des paramètres de résistance équivalents de la pluralité de cellules, et les paramètres historiques du modèle de circuit équivalent de la pluralité de cellules correspondent un à un aux valeurs SoH historiques réelles de la pluralité de cellules ; et
l'obtention d'un modèle de circuit équivalent en temps réel de la première cellule, et l'obtention d'une valeur SoH estimée de la première cellule sur la base du paramètre de modèle de circuit équivalent en temps réel de la première cellule et du modèle d'estimation d'état de batterie de valeur SoH.

10. Procédé selon la revendication 9, dans lequel le procédé comprend également :

l'envoi d'un signal électrique d'excitation de courant alternatif à la première cellule, dans lequel une fréquence du signal électrique d'excitation de courant alternatif est une valeur prédéfinie ;
l'obtention d'un signal d'échantillonnage à partir de la première cellule, dans lequel le signal d'échantillonnage comprend au moins l'une des informations de tension, des informations de courant et des informations de température qui sont de la première cellule ; et
l'obtention d'un paramètre de modèle de circuit équivalent en temps réel de la première cellule comprend :

l'analyse du signal d'échantillonnage et du signal d'excitation à courant alternatif pour obtenir des informations sur le spectre d'impédance de la première cellule ; et
l'obtention du paramètre de modèle de circuit équivalent en temps réel de la première cellule sur la base des informations du spectre d'impédance de la première cellule et d'un modèle de circuit équivalent de batterie, dans lequel
le modèle de circuit équivalent de batterie est préconfiguré ou stocké dans l'unité de surveillance de batterie BMU.

11. Procédé selon la revendication 9 ou 10, dans lequel le procédé comprend également :
l'envoi des paramètres historiques de modèle de circuit équivalent de la pluralité de cellules et des valeurs SoH historiques réelles de la pluralité de cellules au dispositif en nuage.

12. Procédé selon l'une quelconque des revendications 9 à 11, dans lequel le procédé comprend également :
l'envoi, au dispositif en nuage, du paramètre de modèle de circuit équivalent en temps réel de la première cellule et d'une valeur SoH réelle qui est de la première cellule et qui correspond au paramètre de modèle de circuit équivalent en temps réel de la première cellule, dans lequel le paramètre de modèle de circuit équivalent en temps réel de la première cellule et la valeur SoH réelle qui est de la première cellule et qui correspond au paramètre de modèle de circuit équivalent en temps réel de la première cellule sont utilisés par le dispositif en nuage pour mettre à jour le modèle d'estimation d'état de batterie de valeur SoH, pour obtenir un modèle d'estimation d'état de batterie de valeur SoH mis à jour.

13. Procédé selon l'une quelconque des revendications 9 à 12, dans lequel le procédé comprend également :
la réception du modèle d'estimation d'état de batterie de valeur SoH mis à jour à partir du dispositif en nuage.

14. Système de gestion de batterie (100), dans lequel le système comprend un appareil de stockage d'énergie (210) et un dispositif en nuage (220), l'appareil de stockage d'énergie comprend au moins un bloc-batterie (211), le bloc-batterie comprend une pluralité de cellules, la pluralité de cellules sont connectées en série, et la pluralité de cellules comprennent une première cellule ;

le dispositif en nuage est configuré pour envoyer un modèle d'estimation d'état de batterie de valeur SoH à l'appareil de stockage d'énergie, dans lequel le modèle d'estimation d'état de batterie de valeur SoH est obtenu par le dispositif en nuage grâce à un entraînement basé sur les paramètres historiques du modèle de circuit équivalent de la pluralité de cellules et les valeurs SoH historiques réelles de la pluralité de cellules, les paramètres du modèle de circuit équivalent de la pluralité de cellules comprennent au moins l'un des paramètres d'inductance équivalents, des paramètres de capacité équivalents et des paramètres de résistance équivalents de la pluralité de cellules, et les paramètres historiques du modèle de circuit équivalent de la pluralité de cellules correspondent un à un aux valeurs SoH historiques réelles de la pluralité de cellules ; et
l'appareil de stockage d'énergie est configuré pour obtenir un paramètre de modèle de circuit équivalent en temps réel de la première cellule, et obtenir une valeur SoH estimée de la première cellule sur la base du paramètre de modèle de circuit équivalent en temps réel de la première cellule et du modèle d'estimation de la valeur SoH de la batterie.

15. Système selon la revendication 14, dans lequel l'appareil de stockage d'énergie est également configuré pour envoyer le paramètre de modèle de circuit équivalent en temps réel de la première cellule et une valeur SoH réelle qui est de la première cellule et qui correspond au paramètre de modèle de circuit équivalent en temps réel de la première cellule au dispositif en nuage ; et
le dispositif en nuage est également configuré pour mettre à jour le modèle d'estimation d'état de batterie de valeur SoH sur la base du paramètre de modèle de circuit équivalent en temps réel de la première cellule et de la valeur SoH réelle de la première cellule et qui correspond au paramètre de modèle de circuit équivalent en temps réel de la première cellule, pour obtenir un modèle d'estimation d'état de batterie de valeur SoH mis à jour.

| Interface display (energy cloud) | Battery safety 1 | Long battery life 2 | Efficiency 3 | Intelligence 4 |

| Battery management microservice -- result storage | Safety algorithm result data | Life prediction and extended life result data | Efficient algorithm result data | Intelligent battery algorithm result data |

**Management layer**

Application management

Service management

Data management

Battery management microservice -- task management

Safety algorithm task management

Life algorithm task management

Efficient algorithm task management

Intelligent algorithm task management

Algorithm layer

**Mechanism algorithm implementation**

Thermal runaway replacement

Fault detection and warning

Life prediction

Intelligent scheduling

Convergence

**AI algorithm implementation**

Battery safety

Battery life prediction

Battery SoX detection

Message processing

Data processing layer | Data cleansing | Data management

**Control layer**

Device control

Data collection

Access layer (Obtain data from a device, a controller, and a vehicle enterprise platform)

Function control area (Fault bypass, balancing, module-level fire extinguishing, and the like)

Data processing layer (Group sampled data, add a timestamp, and the like)

**Device layer**

End mechanism

Control and execution

Sensing and identification

Terminal side algorithm: fault detection, fault protection, thermal loss controller, intelligent pulse, and SoX calculation

Data collection: voltage, current, period, time, temperature, gas, pressure, light, and the like

FIG. 1

FIG. 2

300

Energy storage apparatus 210

| Battery collection unit 2111 | Battery control unit 212 |

Cloud device 220

S301: Obtain historical equivalent circuit model parameters of a plurality of cells and historical actual SoH values of the plurality of cells

S302: Send the historical equivalent circuit model parameters of the plurality of cells and the historical actual SoH values of the plurality of cells

S303: Perform model training based on the historical equivalent circuit model parameters of the plurality of cells and the historical SoH values of the plurality of cells, to obtain a battery SoH value estimation model

S304: Receive the battery SoH value estimation model

S305: Obtain a real-time equivalent circuit model parameter of a first cell, and obtain an estimated SoH value of the first cell based on the real-time equivalent circuit model parameter of the first cell and the battery SoH value estimation model

S306: Send the real-time equivalent circuit model parameter of the first cell and an actual SoH value that is of the first cell and that corresponds to the real-time equivalent circuit model parameter of the first cell

S307: Update the battery SoH value estimation model based on the real-time equivalent circuit model parameter of the first cell and the actual SoH value that is of the first cell and that corresponds to the real-time equivalent circuit model parameter of the first cell, to obtain an updated battery SoH value estimation model

S308: Receive the updated battery SoH value estimation model

FIG. 3

400

FIG. 4

500

Current/I

ΔI

Time/s

Voltage/V

$\Delta I \cdot Rct \cdot (1 - e^{-t/R\Omega Cdl})$

$\Delta I \cdot R_\Omega$

Time/s

Cdl

$R_\Omega$

Rct

Vocv

FIG. 5

600

SoH value/%

105

100

95

90

85

80

75

70

0          0.05          0.10          0.15          0.20

Equivalent circuit parameter $(Rct \cdot Cdl/R_\Omega^{(1-n)})$

FIG. 6

FIG. 7

EP 4 465 059 B1

**EP 4 465 059 B1**

**Patent documents cited in the description**

- CN 110456279 A